# EUROPEAN PATENT APPLICATION

(11) **EP 3 199 897 A1**
(43) Date of publication of application: **02.08.2017**
(21) Application number: 15843987.7
(22) Date of filing: 15.09.2015
(51) Int. Cl.: F28D 15/02, F25B 41/00, F25B 43/00, H05K 7/20

(54) **REFRIGERANT RELAY DEVICE, COOLING DEVICE USING SAME, AND COOLING METHOD**

(30) Priority: 26.09.2014 JP 2014196362
(71) Applicant: NEC Corporation, Tokyo 108-8001 (JP)
(72) Inventor: MATSUNAGA, Arihiro, Tokyo 108-8001 (JP); SATO, Masanori, Tokyo 108-8001 (JP); SHOUJIGUCHI, Akira, Tokyo 108-8001 (JP); CHIBA, Masaki, Tokyo 108-8001 (JP); YOSHIKAWA, Minoru, Tokyo 108-8001 (JP)
(74) Representative: Vossius & Partner Patentanwälte Rechtsanwälte mbB
(86) International application number: PCT/JP2015/004698
(87) International publication number: WO 2016/047098

(57) **Abstract**

If a gas-liquid separation structure is introduced into a phase-change cooling device to prevent the cooling performance from decreasing, manufacturing costs increase; therefore, a refrigerant intermediary device according to an exemplary aspect of the present invention includes a refrigerant container configured to contain refrigerant; a first inlet, provided for an outer periphery of the refrigerant container, through which a vapor-phase refrigerant and a first liquid-phase refrigerant flowing in; a first outlet, provided for the outer periphery of the refrigerant container, through which the vapor-phase refrigerant flowing out; a second inlet, provided for the outer periphery of the refrigerant container, through which a second liquid-phase refrigerant flowing in; and a second outlet, provided for the outer periphery of the refrigerant container, through which the first liquid-phase refrigerant and the second liquid-phase refrigerant flowing.

## Description

### [Technical Field]

The present invention relates to refrigerant intermediary devices, cooling devices including the refrigerant intermediary devices, and cooling methods, and, in particular, to a refrigerant intermediary device, a cooling device including the refrigerant intermediary device, and a cooling method that are used for cooling electronic equipment and the like,.

### [Background Art]

A phase-change cooling system is known as an example of an efficient cooling system for electronic equipment and the like. In the phase-change cooling system, the heat generated in heat sources such as electronic equipment is received and released using the latent heat of the refrigerant. This system enables the refrigerant to circulate without any power supply due to the buoyancy of refrigerant vapor and the force of gravity on refrigerant liquid. Consequently, the phase-change cooling system makes it possible to cool electronic equipment and the like efficiently with energy saving.

Because the cooling device employing the phase-change cooling system (phase-change cooling device) cools a heating element by transferring the heat from the heating element to refrigerant liquid in a heat receiving unit, a great amount of refrigerant liquid is filled that corresponds to the greatest amount of heat generation. Because refrigerant vapor evaporated due to receiving heat in the heat receiving unit rises involving the surrounding refrigerant liquid of liquid phase, a vapor tube through which the refrigerant vapor flows also contains a relatively large amount of refrigerant liquid. The refrigerant liquid included in the vapor tube, however, becomes a factor for increasing fluid resistance to the refrigerant vapor. This leads to the problem that the cooling performance of the phase-change cooling device decreases.

A technique to solve such a problem is disclosed in Patent Literature 1. An ebullient cooling device for electronic equipment disclosed in Patent Literature 1 includes a jacket, a cooling liquid drive unit, a radiation unit, a tank, and tubes connecting these elements; and an encapsulated refrigerant circulates in the device. The jacket is thermally connected with a heat generating body constituting part of electronic equipment, and propagates heat to the refrigerant circulating inside the jacket. The cooling liquid drive unit drives the refrigerant flowing in the jacket. The radiation unit releases the heat propagated from the jacket to the outside. The tank contains the refrigerant inside.

The tank is connected with the outlet of the jacket, and the internal space of the tank is separated by a porous body into a gas-liquid mixing region and a refrigerant liquid retention region. The refrigerant liquid retention region of the tank is connected to the tube between the radiation unit and the cooling liquid drive unit, and the gas-liquid mixing region is connected to the radiation unit through an opening different from a supply port for the gas-liquid mixing refrigerant from the jacket.

This configuration makes it possible to prevent the liquid from adhering in the tube connecting the jacket and the radiator, and reduce the pressure loss between the jacket and the radiator, according to the ebullient cooling device for electronic equipment disclosed in Patent Literature 1.

### [Citation List]

### [Patent Literature]

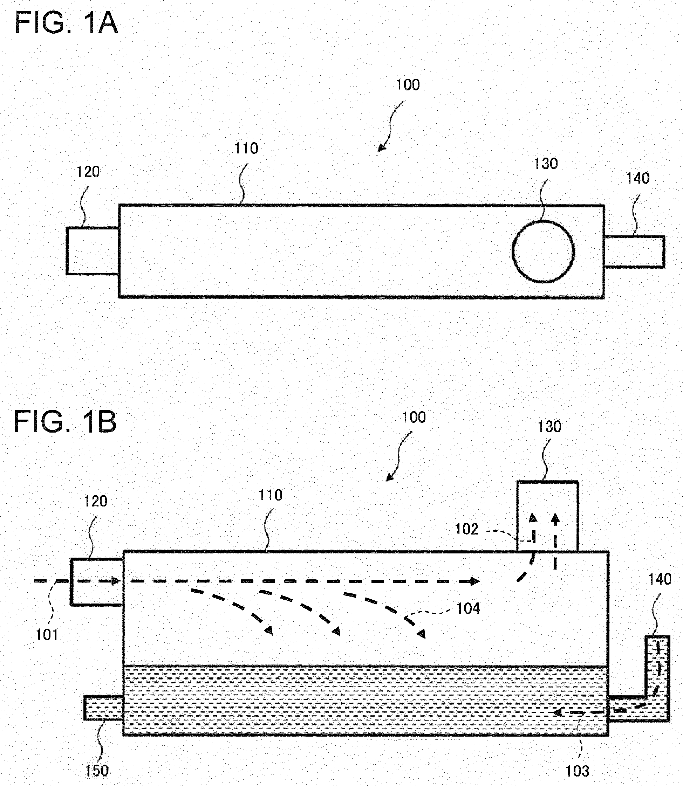

[PTL 1] Japanese Unexamined Patent Application Publication No. 2008-130746 (paragraphs [0015] to [0037], FIG. 1)

### [Summary of Invention]

### [Technical Problem]

As mentioned above, the related ebullient cooling device for electronic equipment disclosed in Patent Literature 1 is configured in which the refrigerant liquid retention region of the tank is connected to the tube between the radiation unit and the cooling liquid drive unit through a bypass tube. This requires inserting a branch tube into the flow path of the refrigerant liquid; consequently, there has been the problem that the tube structure becomes complex.

Thus, there has been the problem that the tube structure becomes complex if a gas-liquid separation structure is introduced into a phase-change cooling device to prevent the cooling performance from decreasing.

The object of the present invention is to provide a refrigerant intermediary device, a cooling device including the refrigerant intermediary device, and a cooling method to solve the problem that the tube structure becomes complex if a gas-liquid separation structure is introduced into a phase-change cooling device to prevent the cooling performance from decreasing.

### [Solution to Problem]

A refrigerant intermediary device according to an exemplary aspect of the present invention includes a refrigerant container configured to contain refrigerant; a first inlet, provided for an outer periphery of the refrigerant container, through which a vapor-phase refrigerant and a first liquid-phase refrigerant flowing in; a first outlet, provided for the outer periphery of the refrigerant container, through which the vapor-phase refrigerant flowing out; a second inlet, provided for the outer periphery of the refrigerant container, through which a second liquid-phase refrigerant flowing in; and a second outlet, provided for the outer periphery of the refrigerant container, through which the first liquid-phase refrigerant and the second liquid-phase refrigerant flowing.

A cooling device including a refrigerant intermediary device according to an exemplary aspect of the present invention includes a heat receiving unit configured to contain refrigerant for receiving heat from a heat source; a condensing unit configured to condense and liquefy the vapor-phase refrigerant that is a vapor-state refrigerant evaporated in the heat receiving unit, and generate the second liquid-phase refrigerant; and a refrigerant intermediary device respectively connected with the heat receiving unit and the condensing unit, wherein the refrigerant intermediary device is located above the heat receiving unit and includes a refrigerant container configured to contain refrigerant; a first inlet, provided for an outer periphery of the refrigerant container, through which a vapor-phase refrigerant and a first liquid-phase refrigerant flowing in; a first outlet, provided for the outer periphery of the refrigerant container, through which the vapor-phase refrigerant flowing out; a second inlet, provided for the outer periphery of the refrigerant container, through which a second liquid-phase refrigerant flowing in; and a second outlet, provided for the outer periphery of the refrigerant container, through which the first liquid-phase refrigerant and the second liquid-phase refrigerant flowing.

A cooling method according to an exemplary aspect of the present invention includes generating a vapor-phase refrigerant of a vapor-state refrigerant and a first liquid-phase refrigerant of a liquid-state refrigerant by receiving heat from a plurality of heat sources; converging streams of the vapor-phase refrigerant generated by each of the plurality of heat sources; separating the first liquid-phase refrigerant; generating a second liquid-phase refrigerant by condensing and liquefying the vapor-phase refrigerant; and generating refrigerant liquid by converging the second liquid-phase refrigerant and the first liquid-phase refrigerant, pooling the refrigerant liquid and then separating the refrigerant liquid into a plurality of fluxes, and circulating the fluxes separated of the refrigerant liquid so as to receive heat from the plurality of heat sources respectively.

### [Advantageous Effects of Invention]

According to the refrigerant intermediary device, the cooling device including the refrigerant intermediary device, and the cooling method of the present invention, it is possible to introduce a gas-liquid separation structure without complexing a tube structure and prevent the cooling performance of the cooling device from decreasing.

### [Brief Description of Drawings]

[FIG. 1A]
   FIG. 1A is a top view illustrating a schematic configuration of a gas-liquid separation structure in accordance with the first example embodiment of the present invention.
[FIG. 1B]
   FIG. 1B is a side cross-sectional view of the gas-liquid separation structure in accordance with the first example embodiment of the present invention.
[FIG. 2]

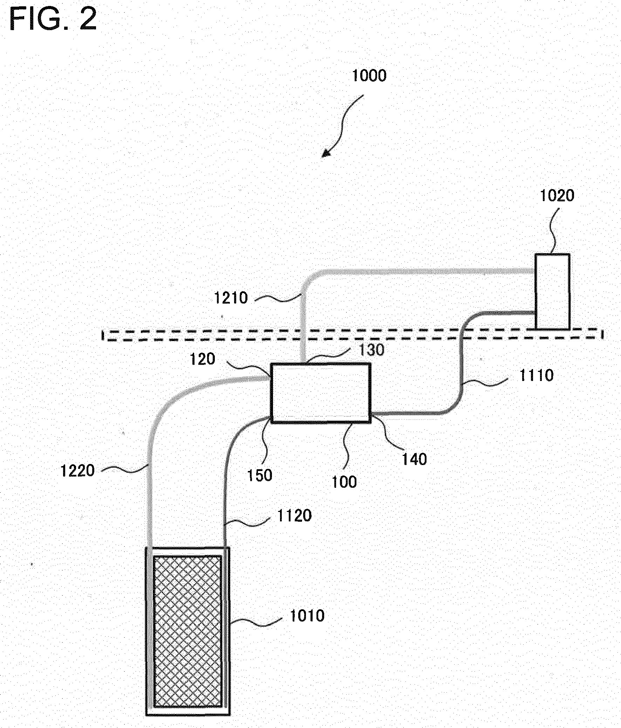

   FIG. 2 is a schematic view of a phase-change cooling device with the gas-liquid separation structure in accordance with the first example embodiment of the present invention.
[FIG. 3A]

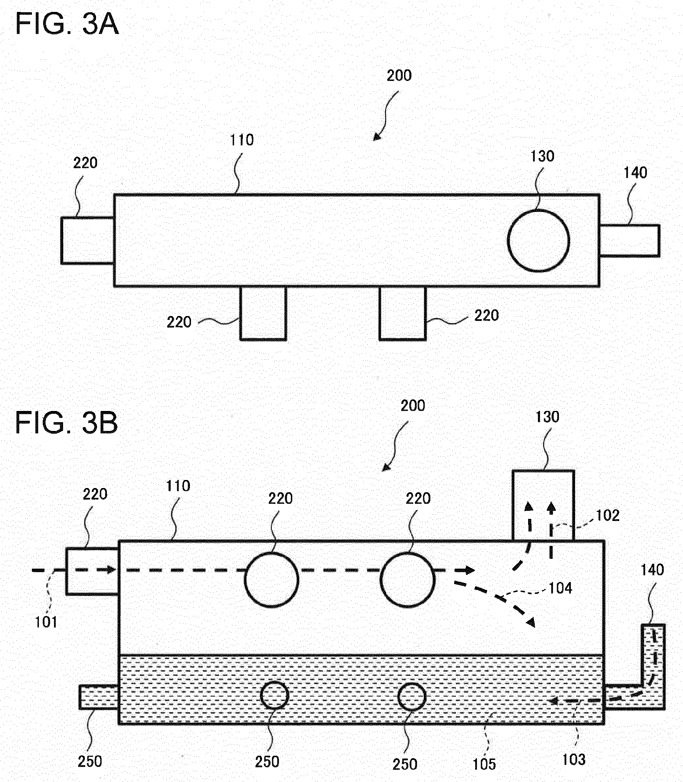

   FIG. 3A is a top view illustrating a schematic configuration of a gas-liquid separation structure in accordance with a second example embodiment of the present invention
[FIG. 3B]
   FIG. 3B is a side cross-sectional view of the gas-liquid separation structure in accordance with the second example embodiment of the present invention.
[FIG. 4]

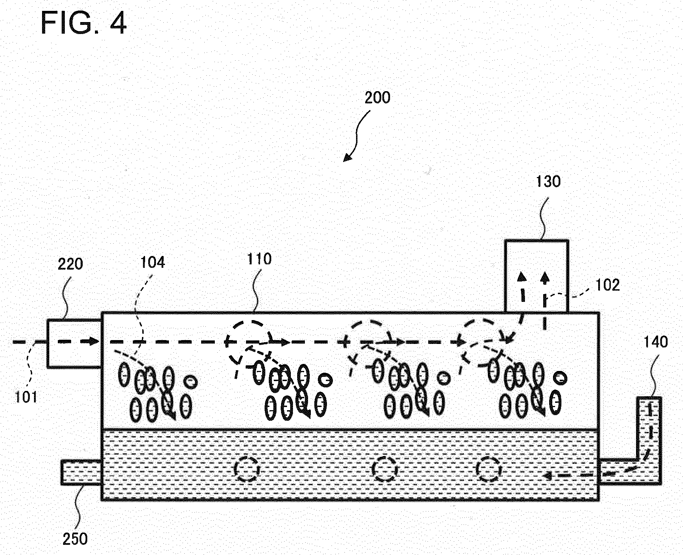

   FIG. 4 is a cross-sectional view for illustrating an advantageous effect of the gas-liquid separation structure in accordance with the second example embodiment of the present invention.
[FIG. 5A]

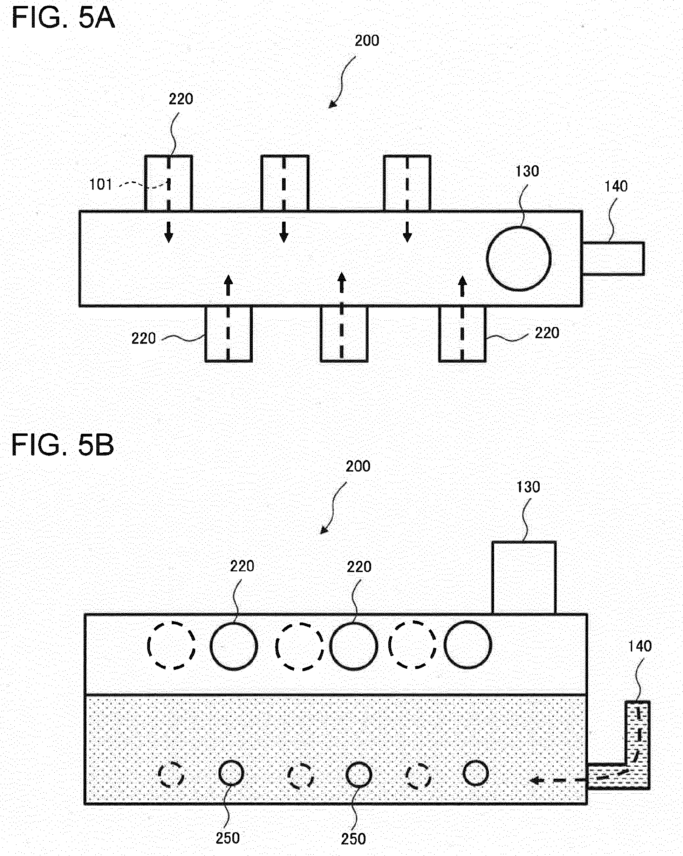

   FIG. 5A is a top view illustrating another schematic configuration of the gas-liquid separation structure in accordance with the second example embodiment of the present invention.
[FIG. 5B]
   FIG. 5B is a side view illustrating another schematic configuration of the gas-liquid separation structure in accordance with the second example embodiment of the present invention.
[FIG. 6A]

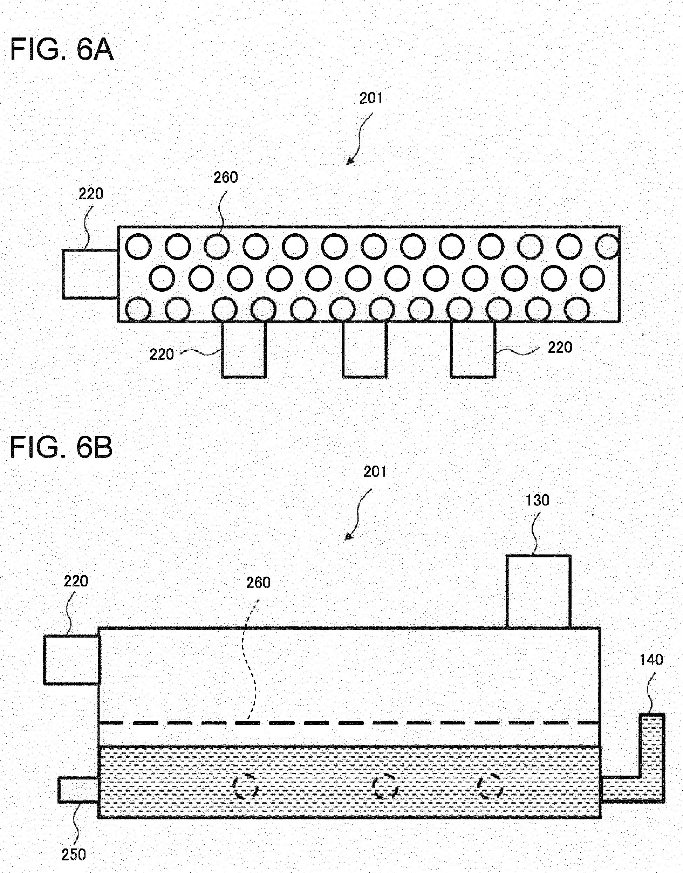

   FIG. 6A is a plane cross-sectional view of yet another schematic configuration of the gas-liquid separation structure in accordance with the second example embodiment of the present invention.
[FIG. 6B]
   FIG. 6B is a side cross-sectional view of yet another schematic configuration of the gas-liquid separation structure in accordance with the second example embodiment of the present invention.
[FIG. 7]

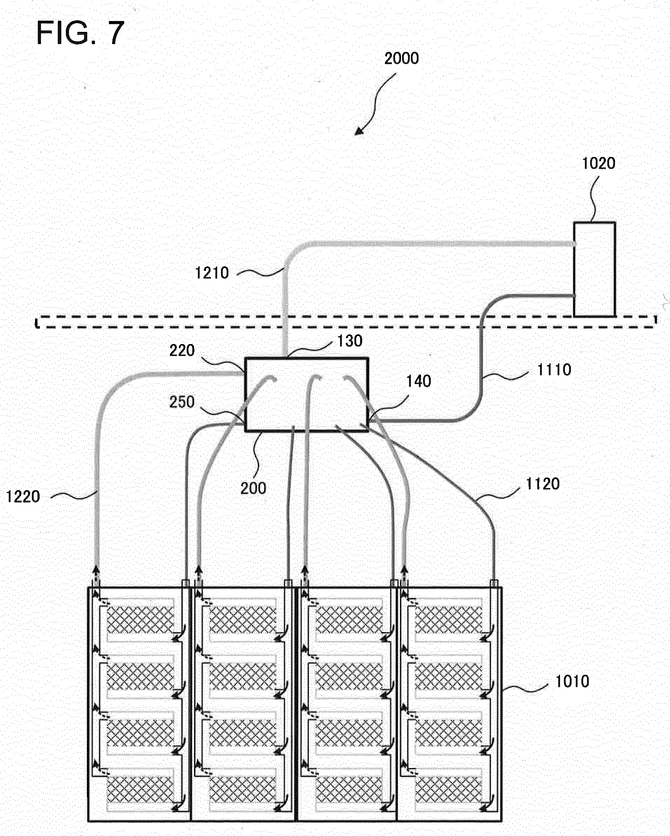

   FIG. 7 is a schematic view of a phase-change cooling device with a gas-liquid separation structure in accordance with a third example embodiment of the present invention.
[FIG. 8]

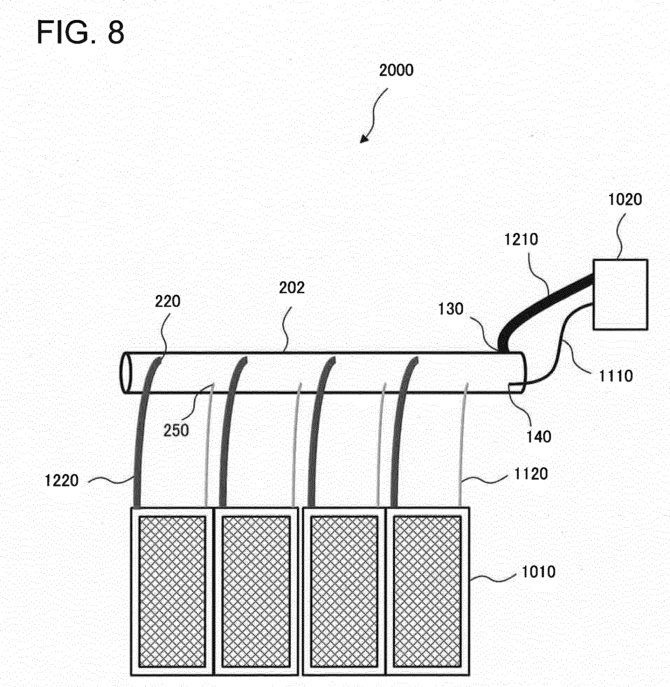

   FIG. 8 is a schematic view of another configuration of the phase-change cooling device with the gas-liquid separation structure in accordance with the third example embodiment of the present invention.
[FIG. 9]

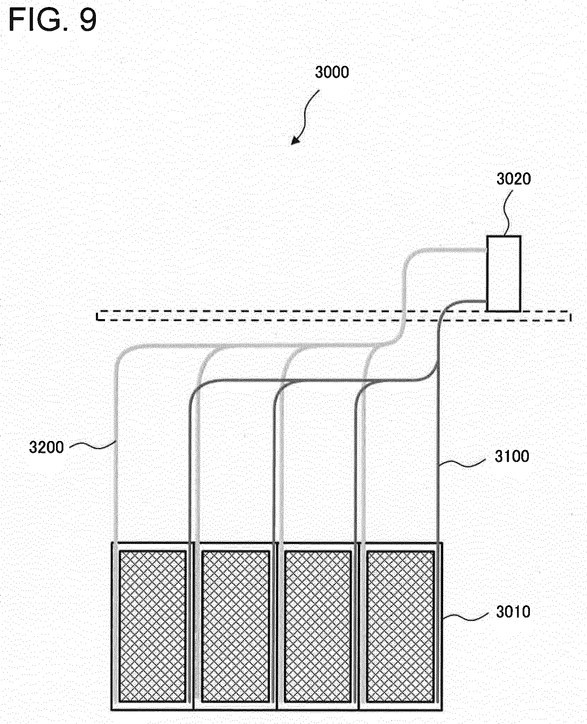

   FIG. 9 is a schematic view illustrating a related phase-change cooling device.

### [Example Embodiment]

Example embodiments of the present invention will be described with reference to drawings below.

### (A first example embodiment)

FIG. 1A and FIG. 1B are schematic views illustrating a configuration of a gas-liquid separation structure 100 in accordance with a first example embodiment of the present invention. FIG. 1A is a top view and FIG. 1B is a side cross-sectional view. The gas-liquid separation structure (refrigerant intermediary device) 100 according to the present example embodiment includes a refrigerant container 110 configured to contain refrigerant, a gas-liquid mixing refrigerant inlet (first inlet) 120, a refrigerant vapor outlet (first outlet) 130, a condensate refrigerant liquid inlet (second inlet) 140, and a refrigerant liquid outlet (second outlet) 150.

The gas-liquid mixing refrigerant inlet 120 is provided for the outer periphery of the refrigerant container 110, and a gas-liquid mixing refrigerant 101 in which a vapor-state refrigerant and a liquid-state refrigerant are mixed flows into the gas-liquid mixing refrigerant inlet 120. The refrigerant vapor outlet 130 is provided for the outer periphery of the refrigerant container 110, and refrigerant vapor (vapor-phase refrigerant) 102 of a vapor-state refrigerant included in the gas-liquid mixing refrigerant 101 flows out through the refrigerant vapor outlet 130. The condensate refrigerant liquid inlet 140 is provided for the outer periphery of the refrigerant container 110, and condensate refrigerant liquid (second liquid-phase refrigerant) 103 resulting from condensing and liquefying the refrigerant vapor 102 flows in through the condensate refrigerant liquid inlet 140. The refrigerant liquid outlet 150 is provided for the outer periphery of the refrigerant container 110, and the condensate refrigerant liquid 103 together with mixed refrigerant liquid (first liquid-phase refrigerant) 104 of a liquid-state refrigerant included in the gas-liquid mixing refrigerant 101 flows out through the refrigerant liquid outlet 150.

According to the gas-liquid separation structure 100 of the present example embodiment, the refrigerant vapor 102 included in the gas-liquid mixing refrigerant (the vapor-phase refrigerant and the first liquid-phase refrigerant) 101 flowing into the refrigerant container 110 flows out from the refrigerant vapor outlet 130, and the mixed refrigerant liquid 104 flows out from the refrigerant liquid outlet 150 together with the condensate refrigerant liquid 103. This makes it possible to remove the mixed refrigerant liquid 104 from the gas-liquid mixing refrigerant 101. Consequently, it is possible to prevent the increase in the fluid resistance to the refrigerant vapor that causes the cooling performance of the phase-change cooling device to decrease.

In the gas-liquid separation structure 100 according to the present example embodiment, the mixed refrigerant liquid 104 flows back to the refrigerant liquid side through the flow path of the condensate refrigerant liquid 103 from the condensate refrigerant liquid inlet 140 toward the refrigerant liquid outlet 150. This eliminates the need for disposing a new tube and inserting a branch tube.

As described above, according to the gas-liquid separation structure 100 of the present example embodiment, it is possible to introduce a gas-liquid separation structure without increasing manufacturing costs and prevent the cooling performance of the phase-change cooling device from decreasing.

Next, a phase-change cooling device including the gas-liquid separation structure 100 according to the present example embodiment will be described.

FIG. 2 illustrates the configuration of a phase-change cooling device 1000 including the gas-liquid separation structure 100 according to the present example embodiment. The phase-change cooling device 1000 according to the present example embodiment includes the gas-liquid separation structure 100, a heat receiving unit 1010, and a condensing unit 1020. The gas-liquid separation structure 100 is located above the heat receiving unit 1010.

The heat receiving unit 1010 contains refrigerant for receiving heat from a heat source. The condensing unit 1020 condenses and liquefies refrigerant vapor that is a vapor-state refrigerant evaporated in the heat receiving unit 1010, and generates condensate refrigerant liquid. The gas-liquid separation structure 100 is connected with the heat receiving unit 1010 and the condensing unit 1020, respectively.

The condensing unit 1020 is connected with the condensate refrigerant liquid inlet of the gas-liquid separation structure 100 by a primary liquid tube 1110. The condensing unit 1020 is connected with the refrigerant vapor outlet of the gas-liquid separation structure 100 by a primary vapor tube 1210. The heat receiving unit 1010 is connected with the refrigerant liquid outlet of the gas-liquid separation structure 100 by a secondary liquid tube 1120. The heat receiving unit 1010 is connected with the gas-liquid mixing refrigerant inlet of the gas-liquid separation structure 100 by a secondary vapor tube 1220.

As illustrated in FIG. 1B, the gas-liquid mixing refrigerant inlet 120 and the refrigerant vapor outlet 130 can be disposed on the outer periphery of the refrigerant container 110 away from the condensate refrigerant liquid inlet 140 and the refrigerant liquid outlet 150. More specifically, as illustrated in FIG. 2, with the gas-liquid separation structure 100 installed in the phase-change cooling device 1000, the gas-liquid mixing refrigerant inlet 120 and the refrigerant vapor outlet 130 can be disposed above the condensate refrigerant liquid inlet 140 and the refrigerant liquid outlet 150. In this case, it is preferable for the gas-liquid mixing refrigerant inlet 120 and the refrigerant vapor outlet 130 to be located above the interface of the refrigerant liquid generated by the convergence of the condensate refrigerant liquid 103 and the mixed refrigerant liquid 104, as illustrated in FIG. 1B.

As mentioned above, according to the phase-change cooling device 1000 including the gas-liquid separation structure 100 of the present example embodiment, it is possible to introduce a gas-liquid separation structure without increasing manufacturing costs and prevent the cooling performance of the phase-change cooling device from decreasing.

### (A second example embodiment)

Next, a second example embodiment of the present invention will be described. FIG. 3A and FIG. 3B illustrate the configurations of a gas-liquid separation structure 200 according to the present example embodiment. FIG. 3A is a top view, and FIG. 3B is a side cross-sectional view.

The gas-liquid separation structure 200 according to the present example embodiment includes a refrigerant container 110 configured to contain refrigerant, a gas-liquid mixing refrigerant inlet 220, a refrigerant vapor outlet 130, a condensate refrigerant liquid inlet 140, and a refrigerant liquid outlet 250.

The gas-liquid mixing refrigerant inlet 220 is provided for the outer periphery of the refrigerant container 110, and a gas-liquid mixing refrigerant 101 in which a vapor-state refrigerant and a liquid-state refrigerant are mixed flows into the gas-liquid mixing refrigerant inlet 220. The refrigerant vapor outlet 130 is provided for the outer periphery of the refrigerant container 110, and refrigerant vapor 102 of a vapor-state refrigerant included in the gas-liquid mixing refrigerant 101 flows out through the refrigerant vapor outlet 130. The condensate refrigerant liquid inlet 140 is provided for the outer periphery of the refrigerant container 110, and condensate refrigerant liquid 103 resulting from condensing and liquefying the refrigerant vapor 102 flows in through the condensate refrigerant liquid inlet 140. The refrigerant liquid outlet 250 is provided for the outer periphery of the refrigerant container 110, and refrigerant liquid 105 resulting from convergence of the condensate refrigerant liquid 103 and mixed refrigerant liquid 104 of a liquid-state refrigerant included in the gas-liquid mixing refrigerant 101 flows out through the refrigerant liquid outlet 150.

The gas-liquid separation structure 200 according to the present example embodiment includes a plurality of gas-liquid mixing refrigerant inlets 220 and a plurality of refrigerant liquid outlets 250. The gas-liquid separation structure 200 differs in this point from the gas-liquid separation structure 100 according to the first example embodiment. The gas-liquid separation structure 200 includes a single refrigerant vapor outlet 130 and a single condensate refrigerant liquid inlet 140, as is the case with the gas-liquid separation structure 100 according to the first example embodiment.

A gas is less dense and larger in volume per unit mass than a liquid. Therefore, it is preferable for the bore of the refrigerant vapor outlet 130, through which the refrigerant vapor 102 flows out, to be larger than the bore of the condensate refrigerant liquid inlet 140 through which the condensate refrigerant liquid 103 flows in.

This configuration enables a phase-change cooling device including a plurality of heat receiving units to use the gas-liquid separation structure 200 according to the present example embodiment. In addition, as described herein below, the gas-liquid separation structure 200 according to the present example embodiment has the function of storing the refrigerant liquid 105 in the refrigerant container 110; consequently, it is possible to supply the refrigerant liquid evenly to the plurality of heat receiving units from the plurality of refrigerant liquid outlets 250.

In the gas-liquid separation structure 200 according to the present example embodiment, the refrigerant vapor 102 included in the gas-liquid mixing refrigerant 101, which flows into the refrigerant container 110 through a plurality of the gas-liquid mixing refrigerant inlets 220, flows out through the refrigerant vapor outlet 130. The mixed refrigerant liquid 104 included in the gas-liquid mixing refrigerant 101 flows out through a plurality of refrigerant liquid outlets 250 together with the condensate refrigerant liquid 103. This makes it possible to remove the mixed refrigerant liquid 104 from the gas-liquid mixing refrigerant 101. Consequently, it is possible to prevent the increase in the fluid resistance to the refrigerant vapor that causes the cooling performance of the phase-change cooling device to decrease.

In the gas-liquid separation structure 200 according to the present example embodiment, the mixed refrigerant liquid 104 flows back to the refrigerant liquid side through the flow path of the condensate refrigerant liquid 103 from the condensate refrigerant liquid inlet 140 toward the refrigerant liquid outlet 250. This eliminates the need for disposing a new tube and inserting a branch tube.

Next, the advantageous effects of the gas-liquid separation structure 200 according to the present example embodiment will be described further in detail.

FIG. 4 is a side cross-sectional view to illustrate the advantageous effects of the gas-liquid separation structure 200 according to the present example embodiment. As illustrated in FIG. 4, the gas-liquid mixing refrigerant 101 including the mixed refrigerant liquid 104 flows into the refrigerant container 110 through the gas-liquid mixing refrigerant inlet 220. At this time, the mixed refrigerant liquid 104 having larger density falls gravitationally and pools in the lower portion of the refrigerant container 110. This makes the mixed refrigerant liquid 104 removed from the gas-liquid mixing refrigerant 101.

The stream of the refrigerant vapor 102 resulting from removing the mixed refrigerant liquid 104 converges with the other streams of the refrigerant vapor 102 flowing in through the plurality of the gas-liquid mixing refrigerant inlets 220, and flows out through the refrigerant vapor outlet 130. Since the mixed refrigerant liquid 104 is not included in the refrigerant vapor 102, it is possible to prevent the pressure loss from increasing. Consequently, it is possible to improve the heat absorption performance of the phase-change cooling device including the gas-liquid separation structure 200 according to the present example embodiment.

The mixed refrigerant liquid 104 is stored in the lower portion of the refrigerant container 110 and flows out through the refrigerant liquid outlet 250. The mixed refrigerant liquid 104 is then distributed to each of the heat receiving units through the tubes connecting the refrigerant liquid outlets 250 with the plurality of heat receiving units constituting the phase-change cooling device. As describe above, the gas-liquid separation structure 200 according to the present example embodiment makes it possible to supply a large amount of refrigerant liquid to each heat receiving unit because the mixed refrigerant liquid 104 included in the gas-liquid mixing refrigerant 101 can be reused for receiving heat. In addition, because the mixed refrigerant liquid 104 is preheated in a state of gas-liquid mixing refrigerant 101, it evaporates on the arrival at the heat receiving unit and absorbs heat from the heat source. This makes it possible to improve heat absorption efficiency of the phase-change cooling device.

As described above, according to the gas-liquid separation structure 200 of the present example embodiment, it is possible to introduce a gas-liquid separation structure without increasing manufacturing costs and prevent the cooling performance of the phase-change cooling device from decreasing.

FIG. 3A and FIG. 3B illustrate a configuration in which the plurality of gas-liquid mixing refrigerant inlets 220 are located on one side surface of the refrigerant container 110. However, the configuration is not limited to this, and a plurality of gas-liquid mixing refrigerant inlets 220 may be disposed, as illustrated in FIG. 5A and FIG. 5B, in positions such that the lines along the inflowing directions of the gas-liquid mixing refrigerant 101 do not intersect one another. In other words, the gas-liquid separation structure 200 can be configured in such a manner that no gas-liquid mixing refrigerant inlet 220 is disposed in a position opposite to another gas-liquid mixing refrigerant inlet 220. This makes it possible to avoid a situation where the streams of the refrigerant vapor 102 included in the gas-liquid mixing refrigerant 101 flowing into through the plurality of the gas-liquid mixing refrigerant inlets 220 prevent the inflow interfering with the stream each other. This configuration makes it possible to prevent the heat absorption performance of the phase-change cooling device from decreasing even though a plurality of heat receiving units constituting the phase-change cooling device are connected by tubes.

FIG. 6A and FIG. 6B illustrate another configuration of the gas-liquid separation structure according to the present example embodiment. FIG. 6A is a plane cross-sectional view, and FIG. 6B is a side cross-sectional view. A gas-liquid separation structure 201 illustrated in the figures includes a partition 260 with a plurality of open holes inside the refrigerant container.

In this case, when the gas-liquid mixing refrigerant 101 including the mixed refrigerant liquid 104 flows into the refrigerant container 110 through the gas-liquid mixing refrigerant inlets 220, the mixed refrigerant liquid 104 falls under its own weight, passes through the open holes of the partition 260, and pools in the lower portion of the refrigerant container 110. In contrast, since the refrigerant vapor 102 flowing into through the gas-liquid mixing refrigerant inlets 220 has a volume flow rate larger than that of the liquid-state refrigerant, a small amount of the refrigerant vapor 102 flows downward passing through the open holes of the partition 260. This makes it possible to avoid a situation where the refrigerant liquid is prevented from flowing from the condensate refrigerant liquid inlet 140 to the refrigerant liquid outlets 250 below the partition 260 by the refrigerant vapor 102 flowing in the opposite direction. As a result, it is possible to improve the heat absorption performance of the phase-change cooling device including the gas-liquid separation structure 201.

### (A third example embodiment)

A third example embodiment of the present invention will be described below. FIG. 7 illustrates the configuration of a phase-change cooling device 2000 including a gas-liquid separation structure according to the present example embodiment. The phase-change cooling device 2000 according to the present example embodiment includes a gas-liquid separation structure 200, a heat receiving unit 1010, and a condensing unit 1020. The gas-liquid separation structure 200 is located above the heat receiving unit 1010. The configuration of the gas-liquid separation structure 200 is similar to the configurations described in the second example embodiment, including the gas-liquid separation structure 201.

The heat receiving unit 1010 includes a plurality of units, each of which contains refrigerant to receive heat from a heat source. The condensing unit 1020 condenses and liquefies refrigerant vapor of a vapor-state refrigerant evaporated in the heat receiving unit 1010, and generates condensate refrigerant liquid. The gas-liquid separation structure 200 is connected with the plurality of heat receiving units 1010 and the condensing unit 1020, respectively.

As mentioned above, the gas-liquid separation structure 200 according to the present example embodiment has a plurality of gas-liquid mixing refrigerant inlets 220 and a plurality of refrigerant liquid outlets 250. In contrast, the gas-liquid separation structure 200 has a single refrigerant vapor outlet 130 and a single condensate refrigerant liquid inlet 140.

A primary liquid tube 1110 connects the condensing unit 1020 with the condensate refrigerant liquid inlet 140 of the gas-liquid separation structure 200. A primary vapor tube 1210 connects the condensing unit 1020 with the refrigerant vapor outlet 130 of the gas-liquid separation structure 200. In contrast, a plurality of secondary liquid tubes 1120 respectively connect the plurality of heat receiving units 1010 with the plurality of refrigerant liquid outlets 250 of the gas-liquid separation structure 200. A plurality of secondary vapor tubes 1220 respectively connect the plurality of heat receiving units 1010 with the plurality of gas-liquid mixing refrigerant inlets 220 of the gas-liquid separation structure 200.

As described above, the phase-change cooling device 2000 according to the present example embodiment is configured such that the plurality of heat receiving units 1010 are connected with a single gas-liquid separation structure 200 by the plurality of secondary liquid tubes 1120 and the plurality of secondary vapor tubes 1220. This configuration makes it possible to remove the mixed refrigerant liquid 104 from the gas-liquid mixing refrigerant 101 in the gas-liquid separation structure 200, converge the streams of the refrigerant vapor flowing into through the plurality of secondary vapor tubes 1220, and distribute the refrigerant liquid evenly among the plurality of heat receiving units 1010.

In addition, the phase-change cooling device 2000 according to the present example embodiment is configured such that the single condensing unit 1020 is connected with the plurality of heat receiving units 1010, which enables the cost of the phase-change cooling device to decrease.

If a single condensing unit is connected with a plurality of heat receiving units, the mixed refrigerant liquid included in gas-liquid mixing refrigerant flowing through one of the secondary vapor tubes 1220 can flow into another heat receiving unit 1010 through another secondary vapor tube 1220. The mixed refrigerant liquid having flowed into another secondary vapor tube 1220 obstructs the flow of the refrigerant vapor and affects the heat absorption performance of the heat receiving unit 1010; consequently, the amount of the heat absorption becomes unequal. This makes it impossible to achieve desired heat absorption performance in the heat receiving units 1010.

However, according to the phase-change cooling device 2000 including the gas-liquid separation structure 200 of the present example embodiment, it is possible to remove the mixed refrigerant liquid from the gas-liquid mixing refrigerant in the gas-liquid separation structure 200. This makes it possible to prevent the mixed refrigerant liquid from flowing into another heat receiving unit 1010 through another secondary vapor tube.

The heat receiving unit 1010 includes a plurality of evaporation units each of which is thermally connected with a heat source and stores refrigerant, and the plurality of evaporation units can be located in a vertical direction. More specifically, for example, a plurality of servers that serve as heat sources are stacked in a server rack, and a heat receiving module including an evaporating unit disposed on the rear door or the like of the server rack can serve as the heat receiving unit 1010. The gas-liquid separation structure 200 can be located above the server rack and outside the rear door on which the heat receiving unit 1010 is disposed.

Next, the configuration of the phase-change cooling device 2000 including the gas-liquid separation structure 200 according to the present example embodiment will be describe further in detail.

The refrigerant container 110 can be composed of a rectangular parallelepiped shaped container, as illustrated in FIG. 3A and FIG. 3B. In this case, a plurality of gas-liquid mixing refrigerant inlets 220 can be located on the upper part of the side surface of the container, and a single refrigerant vapor outlet 130 can be located on the upper surface of the container. A single condensate refrigerant liquid inlet 140 can be located on the lower part of the side surface of the container, and a plurality of refrigerant liquid outlets 250 can be located on at least one of the lower part of the side surface of the container and the undersurface of the container.

The amount of the refrigerant with which the entire phase-change cooling device 2000 is filled is set so that the liquid level of the refrigerant liquid 105 contained in the refrigerant container 110 of the gas-liquid separation structure 200 may be kept constant during the operating condition, as illustrated in FIG. 3B. The refrigerant vapor outlet 130 is located above the liquid level of the refrigerant liquid 105, and the condensate refrigerant liquid inlet 140 is located below the liquid level of the refrigerant liquid 105. The liquid level of the refrigerant liquid 105 fluctuates depending on the pressure losses in each heat receiving unit 1010, the primary vapor tube 1210, or the secondary vapor tubes 1220. The refrigerant liquid outlet 250 is located on the undersurface of the container again, which makes it possible to deliver a steady supply of the refrigerant liquid 105 to each heat receiving unit 1010 through the refrigerant liquid outlet 250 even though the liquid level of the refrigerant liquid 105 fluctuates.

Alternatively, the phase-change cooling device 2000 can be configured to include a gas-liquid separation structure 202 with a refrigerant container composed of a cylindrical tube, as illustrated in FIG. 8. The gas-liquid separation structure 202 can be configured in which a plurality of gas-liquid mixing refrigerant inlets 220 and a single refrigerant vapor outlet 130 are located on the upper surface of the tube, and a single condensate refrigerant liquid inlet 140 and a plurality of refrigerant liquid outlets 250 are located on the undersurface of the tube. In this case, it becomes possible to manufacture the gas-liquid separation structure 202 using conventional, low-cost pipes, which makes it possible to lower significantly the manufacturing cost of the phase-change cooling device 2000.

Next, the advantageous effects of the phase-change cooling device 2000 including the gas-liquid separation structure according to the present example embodiment will be described further in detail.

FIG. 9 illustrates a related phase-change cooling device 3000 that serves as a comparative example, in which a plurality of heat receiving units 3010 are connected with a single condensing unit 3020 by means of a plurality of liquid tubes 3100 and a plurality of vapor tubes 3200 without using a gas-liquid separation structure. In this case, a heat receiving unit 3010 disposed farther away from the condensing unit 3020 suffers a greater pressure loss of the refrigerant vapor flowing in the vapor tube 3200. This makes it difficult to achieve uniform heat absorption performance between the pluralities of heat receiving units 3010.

In contrast, the phase-change cooling device 2000 according to the present example embodiment is configured to store the refrigerant liquid in the gas-liquid separation structure 200, 202 and then distribute the refrigerant liquid to each heat receiving unit 1010, as illustrated in FIG. 7 and FIG. 8. This makes it possible to equalize the pressure to supply the refrigerant liquid to each heat receiving unit 1010 and distribute the refrigerant liquid equally. In other words, the plurality of secondary vapor tubes 1220 are connected with the single gas-liquid separation structure 200, which makes it possible to equalize each pressure in the plurality of gas-liquid mixing refrigerant inlets 220. This enables the pressure required for the refrigerant liquid to flow into each of the secondary liquid tubes 1120 to become equal to each other. This makes it possible to eliminate imbalances in the amount of heat absorption in each heat receiving unit 1010 and improve the heat absorption performance.

Next, a phase-change cooling method according to the present example embodiment will be described.

In the phase-change cooling method according to the present example embodiment, first, a gas-liquid mixing refrigerant in which a vapor-state refrigerant and a liquid-state refrigerant are mixed is generated by receiving heat from a plurality of heat sources. Streams of refrigerant vapor of the vapor-state refrigerant generated by each of the plurality of heat sources are then converged. At this time, mixed refrigerant liquid that is a liquid-state refrigerant included in the gas-liquid mixing refrigerant is separated. After that, condensate refrigerant liquid is generated by condensing and liquefying the refrigerant vapor, and refrigerant liquid in which the condensate refrigerant liquid is converged with the mixed refrigerant liquid is generated. The refrigerant liquid is pooled and then separated into a plurality of fluxes, and the separated fluxes of the refrigerant liquid are respectively circulated so as to receive heat from the plurality of heat sources.

This makes it possible to perform a gas-liquid separation of refrigerant without increasing manufacturing costs and prevent the cooling performance of the phase-change cooling system from decreasing.

Hereinabove, the present invention has been described using the above-described example embodiments as exemplary examples. The present invention, however, is not limited to the above-described example embodiments. In other words, various aspects that can be recognized by those skilled in the art can be applied to the present invention within the scope of the invention.

This application is based upon and claims the benefit of priority from Japanese Patent Application No. 2014-196362, filed on September 26, 2014, the disclosure of which is incorporated herein in its entirety by reference.

### [Reference Signs List]

- 100, 200, 201, 202: gas-liquid separation structure
- 101: gas-liquid mixing refrigerant
- 102: refrigerant vapor
- 103: condensate refrigerant liquid
- 104: mixed refrigerant liquid
- 105: refrigerant liquid
- 110: refrigerant container
- 120, 220: gas-liquid mixing refrigerant inlet
- 130: refrigerant vapor outlet
- 140: condensate refrigerant liquid inlet
- 150, 250: refrigerant liquid outlet
- 260: partition
- 1000, 2000: phase-change cooling device
- 1010, 3010: heat receiving unit
- 1020, 3020: condensing unit
- 1110: primary liquid tube
- 1210: primary vapor tube
- 1120: secondary liquid tube
- 1220: secondary vapor tube
- 3000: related phase-change cooling device
- 3100: liquid tube
- 3200: vapor tube

## Claims

1. A refrigerant intermediary device, comprising:
a refrigerant container configured to contain refrigerant;
a first inlet, provided for an outer periphery of the refrigerant container, through which a vapor-phase refrigerant and a first liquid-phase refrigerant flowing in;
a first outlet, provided for the outer periphery of the refrigerant container, through which the vapor-phase refrigerant flowing out;
a second inlet, provided for the outer periphery of the refrigerant container, through which a second liquid-phase refrigerant flowing in; and
a second outlet, provided for the outer periphery of the refrigerant container, through which the first liquid-phase refrigerant and the second liquid-phase refrigerant flowing.

2. The refrigerant intermediary device according to claim 1,
wherein the first inlet and the first outlet are located on the outer periphery of the refrigerant container away from the second inlet and the second outlet.

3. The refrigerant intermediary device according to claim 1 or 2,
wherein the first inlet includes a plurality of inlets,
the first outlet inlet includes a single outlet,
the second inlet includes a single inlet, and
the second outlet includes a plurality of outlets.

4. The refrigerant intermediary device according to claim 3,
wherein the plurality of inlets of the first inlet are located in positions such that lines along inflowing directions of the vapor-phase refrigerant and the first liquid-phase refrigerant do not intersect one another.

5. The refrigerant intermediary device according to any one of claims 1, 2, 3, and 4,
wherein the refrigerant container is composed of a rectangular parallelepiped shaped container,
the first inlet is located on an upper part of a side surface of the container,
the first outlet is located on an upper surface of the container,
the second inlet is located on a lower part of a side surface of the container, and
the second outlet is located on at least on one of a lower part of a side surface of the container and an undersurface of the container.

6. The refrigerant intermediary device according to any one of claims 1, 2, 3, and 4,
wherein the refrigerant container is composed of a cylindrical tube.

7. The refrigerant intermediary device according to any one of claims 1, 2, 3, 4, 5, and 6, further comprising a partition with a plurality of open holes inside the refrigerant container.

8. A cooling device including a refrigerant intermediary device, comprising:
a refrigerant intermediary device according to any one of claims 1, 2, 3, 4, 5, 6, and 7;
a heat receiving unit configured to contain refrigerant for receiving heat from a heat source; and
a condensing unit configured to condense and liquefy the vapor-phase refrigerant that is a vapor-state refrigerant evaporated in the heat receiving unit, and generate the second liquid-phase refrigerant,
wherein the refrigerant intermediary device is respectively connected with the heat receiving unit and the condensing unit, and located above the heat receiving unit.

9. The cooling device including the refrigerant intermediary device according to claim 8, further comprising
a primary vapor tube connecting the condensing unit with the first outlet,
a primary liquid tube connecting the condensing unit with the second inlet,
a secondary vapor tube connecting the heat receiving unit with the first inlet, and
a secondary liquid tube connecting the heat receiving unit with the second outlet.

10. The cooling device including the refrigerant intermediary device according to claim 8 or 9,
wherein the heat receiving unit includes a plurality of evaporation units each of which is thermally connected with the heat source and stores the refrigerant, and
the plurality of evaporation units are located in a vertical direction.

11. A cooling method, comprising:
generating a vapor-phase refrigerant of a vapor-state refrigerant and a first liquid-phase refrigerant of a liquid-state refrigerant by receiving heat from a plurality of heat sources;
converging streams of the vapor-phase refrigerant generated by each of the plurality of heat sources;
separating the first liquid-phase refrigerant;
generating a second liquid-phase refrigerant by condensing and liquefying the vapor-phase refrigerant; and
generating refrigerant liquid by converging the second liquid-phase refrigerant and the first liquid-phase refrigerant, pooling the refrigerant liquid and then separating the refrigerant liquid into a plurality of fluxes, and circulating the fluxes separated of the refrigerant liquid so as to receive heat from the plurality of heat sources respectively.
